# EUROPEAN PATENT APPLICATION

(11) **EP 1 167 485 A1**
(43) Date of publication of application: **02.01.2002**
(21) Application number: 01305606.4
(22) Date of filing: 27.06.2001
(51) Int. Cl.: C09K 3/14, B24D 3/06, C22C 26/00

(54) **CVD titanium-boron or chromium-boron coating of diamond**

(30) Priority: 28.06.2000 US 605120
(71) Applicant: GENERAL ELECTRIC COMPANY, Schenectady, NY 12345 (US)
(72) Inventor: Meng, Yue, Columbus, Ohio 43235 (US)
(74) Representative: Szary, Anne Catherine, Dr.

(57) **Abstract**

Disclosed is a method for coating diamond to achieve a more advanced coating of high oxidation resistance and stronger retention force, which includes chemical vapor depositing (CVD) a metal layer material selected from one or more of Ti₍₁₋ₓ₎Bₓ or Cr₍₁₋ₓ₎Bₓ where x is ≤ 0.05, on substantially all of the outer surfaces of said diamond. Also disclosed is a ferrous or other workpiece having embedded therein diamond having substantially all of its outer surfaces coated with one or more of Ti₍₁₋ₓ₎Bₓ or Cr₍₁₋ₓ₎Bₓ where x is ≤ 0.05. Further disclosed coated diamond that has substantially all of its outer surfaces coated with one or more of Ti₍₁₋ₓ₎Bₓ or Cr₍₁₋ₓ₎Bₓ, where x is ≤ 0.05.

## Description

The present invention relates to the coating of diamond for its use in components/implements that may contain iron, and more particularly to an improved Ti or Cr coating that contains a trace amount of B.

Superabrasive grit, such as diamond particles, is widely used in sawing, drilling, dressing, grinding, lapping, polishing, and other abrading applications. For these applications, the grit typically is surrounded in a matrix of a metal, such as Ni, Cu, Fe, Co, Sn, W, Ti, or an alloy thereof; or of a resin, such as phenol formaldehyde or other thermosetting polymeric material. By attaching the matrices to a body or other support, tools may be fabricated having the capability to cut through hard, abrasive materials such as, for example, concrete, asphalt, masonry, ceramic, brick, or granite, marble, or other rock. Exemplary of such tools is a saw blade as disclosed in U.S. Patent No. 4,883,500, which is comprised of a circular steel disk having a number of spaced segments disposed about its cutting edge. Each of the segments includes an amount of single crystal diamond (or diamond grit) dispersed in a suitable bonding matrix of a metal or alloy, such as Co, bronze, cemented metal carbide, or the like.

The retention of diamond grit within the matrix primarily involves a mechanical component developed from the surrounding of the individual particles by the matrix. The exposure of the grit, accordingly, must be limited so as not to critically weaken the mechanical properties of the surrounding matrix on the grit particles. For example, in a typical saw blade application, the average exposure of the grit is less than about 20% of the total grit height. The limited grit exposure, in turn, limits the cutting rate. Moreover, as the matrix is ablatively worn during its use, the service life of the tool may be shortened, because up to two-thirds of the grit may be prematurely lost by its being pulled or popped out of the surrounding matrix.

In an attempt to improve grit retention, it has been proposed to coat diamond particles with carbide-forming transition metals, such as, for example, Mo, Ti, and Cr. Such metals typically are chemically vapor deposited (CVD) or sputtered onto the surfaces of the diamond grit. Examples of such coatings and processes for the deposition thereof are disclosed in U.S. Patents Nos. 3,465,916, 3,650,714, 3,879,901, 4,063,907, 4,378,975, 4,399,167, and 4,738,689; U.S. Reissue No. 34,133; and EP-A79/300,337.7. It has been reported, however, that these coatings may be oxidized and, depending upon the carbide formed, may be brittle. In response, proposals have been made to use a carbide-forming metal layer as part of a multi-layer coating system. As is described in U.S. Patents Nos. 3,929,432, 5,024,680, 5,062,865, and 5,232,469, such multi-layer coating systems generally involve the vapor-phase deposition of an inner layer of a thin (0.05 to 15 micron thick) carbide-forming metal, and an outer layer of a more corrosion resistant metal, such as Ni or Cu, for protecting the inner layer from oxidation.

Inasmuch as diamond reacts with ferrous materials at high temperature, which degrades its performance, Ti and Cr coatings have been proposed to separate the diamond from the iron content of the matrix. Unfortunately, Fe still can diffuse through the thin coating layer and adversely react with the diamond. Thus, there is a need in the art for improved diamond coatings for their use in ferrous as well as other matrices.

Disclosed is a method for coating diamond for its use in ferrous and other matrices, which method includes chemical vapor depositing (CVD) a metal layer material selected from one or more of Ti₍₁₋ₓ₎Bₓ or Cr₍₁₋ₓ₎Bₓ, where x is ≤ 0.05, on substantially all of the outer surfaces of said diamond. Also disclosed is a ferrous or other workpiece having embedded therein diamond having substantially all of its outer surfaces coated with one or more of Ti₍₁₋ₓ₎Bₓ or Cr₍₁₋ₓ₎Bₓ, where x is ≤ 0.05. Further disclosed is a coated diamond that is suitable for use in ferrous and other workpieces, wherein the diamond has substantially all of its outer surfaces coated with one or more of Ti₍₁₋ₓ₎Bₓ or Cr₍₁₋ₓ₎Bₓ, where x is ≤ 0.05.

### DETAILED DESCRIPTION OF THE INVENTION

The TiB and CrB coatings are a more advanced coating than the conventional Ti and Cr coatings. The chemistry of these coating layers primarily is Ti and Cr, with a trace amount of added boron. Studies have shown that such coatings provide a stronger retention force between the coated diamond grit and the surrounding matrix due to the existence of the trace amount of elemental boron that improves wetting and sintering between the coating layer and the surrounding matrix. The benefit of this advanced property is in utilizing ultra high-grade diamond grit in conventional matrixes to produce high performance diamond tools.

Ultra high-grade diamond grit is grit with "perfect" internal crystalline structure and externally more symmetric shape and smoother surfaces. This grit has a higher mechanical strength and is expected to significantly improve the performance of diamond tools. In initial studies, one problem encountered in using such ultra high-grade diamond grit was that a large percentage of grit was pulled out of its surrounding matrix, resulting in poor tool performance. The problem was caused by insufficient retention of the grit in the matrix. As the quality of diamond grit improves, the shape of the grit become more symmetrical and the surfaces become smoother. Consequently, a larger retention force is required to hold the grit in the matrix. Studies have demonstrated that the disclosed coatings provide stronger bond (matrix) retention such that ultra high-grade diamond grit can now be held in conventional bond systems. Moreover, diamond tool performance is significantly improved when the new coatings are used. Typical diamond sizes for coating and for use in workpiece matrices range from about 5 to about 1000 µ.

The new coatings also provide a better-sealed coating layer. Inspection of the coated grit using SEM (scanning electron microscopy) has revealed that the new coatings have a more uniform texture than conventional Ti and Cr coatings. The new coating layers further have improved oxidation resistance. These new properties in combination (*viz*., better sealing and a more uniform texture) enable the new coating to provide improved protection to diamond grit from being oxidized during tool making process. If the tool is composed of a ferrous substance, for example iron, the new coating layer protects the diamond grit from reacting with the ferrous substance in the matrix. In this regard the thickness of the Ti₍₁₋ₓ₎Bₓ or Cr₍₁₋ ₓ₎Bₓ coating ranges from about 0.8 to about 2 wt-%.

Boron is known to substitute for carbon in the diamond structure that improves the oxidation resistance and chemical stability in a ferrous environment. Researchers also have shown that trace amounts of boron in Fe improves the creep strength of Fe (summarized by Brown, *et al*., *Metal Science,* 1974, vol. 8, 317, the disclosure of which is expressly incorporated herein by reference). Thus, the Ti₍₁₋ₓ₎Bₓ or Cr₍₁₋ₓ₎Bₓ, where x is ≤ 0.05, coating may result in the formation of boron carbide on the surface of the diamond for the prevention or reduction of undesirable reactions of Fe with the diamond and by the diffusion of boron atoms into the iron bond with consequent improvement of the mechanical property of the bond.

At this point in the description, it should be understood that when using the formulas, Ti₍₁₋ₓ₎Bₓ or Cr₍₁₋ₓ₎Bₓ, where x is ≤ 0.05, that X equals about 0.05 is an upper limit of boron in the process. Concentrations of B higher than about 0.05 create an opportunity of degrading coating quality. The composition of the coating layer on diamond grit after reaction, thus, likely is not exactly 0.05. Direct data on the composition is not possible since no commercial characterization techniques are able to provide an accurate measurement of such low levels of boron. The existence of boron in coating layer is derived indirectly.

The Ti/B and Cr/B coatings can be applied by conventional chemical vapor deposition techniques, such as taught by S. Sivaram, *Chemical Vapor Deposition: Thermal and Plasma Deposition of Electronic Materials,* 1995 (ISBN # 0-442-01079-6).

While the invention has been described with reference to a preferred embodiment, those skilled in the art will understand that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims. In this application all units are in the metric system and all amounts and percentages are by weight, unless otherwise expressly indicated. Also, all citations referred herein are expressly incorporated herein by reference.

### EXAMPLES

### EXAMPLE 1

Diamond grit (40/45 mesh) was CVD coated with TiB containing less than 5 wt-% B content at varying temperatures. A Ti only conventional coating also was applied to the diamond grit for comparison purposes. The resulting coating thickness (measured in weight-%) then was determined with the following results being recorded.

**TABLE 1**

| Coating Type | Coating Temp, (°C) | Coating Time (hr) | Wt-% of Coating |
|---|---|---|---|
| TiB | 800 | 2.0 | 0.35 |
| TiB | 930 | 2.0 | 0.98 |
| TiB | 910 | 2.5 | 1.22 |
| Ti | 900 | 2.0 | 1.00 |

The above-tabulated data shows that coating diamond grit with TiB proceeds much like coating with Ti alone in terms of coating times and temperatures versus coating thickness.

### EXAMPLE 2

Diamond grit (45/50 mesh) was again CVD coated with TiB having less than 5 wt-% B content. The boron for the coating was supplied by an amorphous B source and by a B₄C source. Again, a comparative Ti only coated diamond grit product also was prepared. The final coating was about 1 wt-% of the total weight of the samples. The samples then were subjected to Thermogravimetric Analysis, which is a continuous measurement of sample weight under elevated temperature conditions in a static "air" atmosphere. A decrease in sample weight is indicative of volatile reaction products being evolved from the sample. For diamond, oxygen will react at elevated temperature to form CO, CO₂, and mixtures thereof. J. E. Field (Editor), *The Properties of Diamond,* Academic Press, New York, New York (1979). TGA curves reported herein were generated on a 951 Thermogravimetric Analyzer by DuPont Instruments with all samples being placed on a platinum sample holder. The temperature was increased at a rate of 10° C/min.

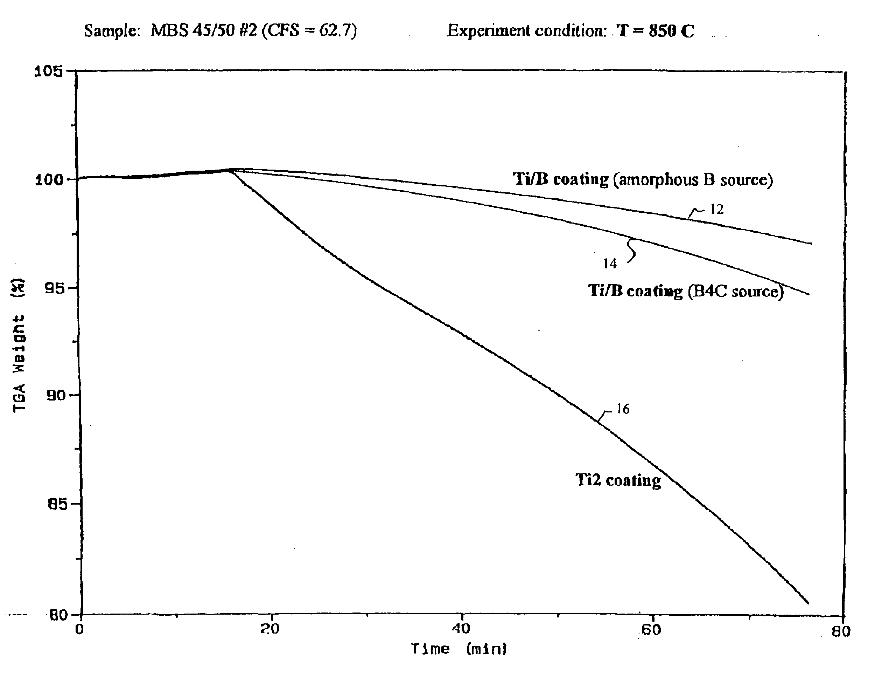

The results recorded are set forth in Fig. 1, wherein line 12 represents the TiB coating from an amorphous B source, line 14 represents the TiB coating from a B₄C source, and line 16 represents the comparative Ti coating. These results demonstrate that the TiB coated diamond grit were more resistant to oxidation degradation than the conventionally Ti coated grit.

### EXAMPLE 3

The performance of the inventive coating was evaluated in granite sawing and concrete sawing applications using ultra-high quality diamond grit (compression fracture strength > 70 Ib and aspect ration of < 1.08) in bronze and Co-based bond system.

The samples tested were prepared again by CVD coating diamond grit (40/50 mesh) with Cr (comparative), TiB having less than 5 wt-% B content (duplicate samples), and uncoated grit. The following test results were recorded:

**TABLE 2**

| Sample No. | Abrasive Type | Wear Performance* |
|---|---|---|
| A | Uncoated | 100 |
| B | Cr Coated | 102 |
| C | TiB Coated | 144 |
| D | TiB Coated | 154 |

| | | |
|---|---|---|
| * Normalized to 100 for the uncoated grit. | | |

The above-tabulated results again demonstrate that the inventive TiB coated grit exhibits better bond retention as reflected by its improved wear performance. Such bond retention refers both to retention of the TiB coating by the diamond grit as well as the retention of the coated grit by the bond.

## Claims

1. A method for improving the retention of diamond particles in a workpiece matrix, which comprises:
(a) coating a metal layer material selected from one or more of Ti₍₁₋ₓ₎Bₓ or Cr₍₁₋ₓ₎Bₓ, where x is ≤ 0.05, on substantially all of the outer surfaces of said diamond; and
(b) incorporating said coated diamond in a workpiece matrix.

2. The method of claim 1, wherein said workpiece matrix is a ferrous matrix.

3. The method of claim 1 or claim 2, wherein said diamond is coated by chemical vapor deposition (CVD).

4. The method of any preceding claim, wherein said diamond is ultra high-grade diamond.

5. The method of any preceding claim, wherein said diamond ranges in size from about 5 to about 1000 µm.

6. The method of any preceding claim, wherein said coating ranges in thickness from about 0.01 to 1.5 µm.

7. A ferrous workpiece having embedded therein diamond particles, substantially all of the exterior surfaces of which have been coated with Ti₍₁₋ ₓ₎Bₓ or Cr₍₁₋ₓ₎Bₓ, where x is ≤ 0.05.

8. The ferrous workpiece of claim 7, wherein said diamond is coated by chemical vapor deposition (CVD).

9. The ferrous workpiece of claim 7 or claim 8, wherein said diamond is ultra high-grade diamond.

10. The ferrous workpiece of any one of claims 7, 8 or 9, wherein said diamond ranges in size from about 5 to about 1000 µm.

11. The ferrous workpiece of any one of claims 7, 8, 9 or 10, wherein said coating ranges in thickness from about 0.01 to 1.5 µm.

12. Coated diamond particles suitable for use in ferrous workpieces, comprising diamond particles substantially all of the exterior surfaces of which have been coated with Ti₍₁₋ₓ₎Bₓ or Cr₍₁₋ₓ₎Bₓ, where x is ≤ 0.05.

13. The coated diamond particles of claim 12, wherein said diamond is coated by chemical vapor deposition (CVD).

14. The coated diamond particles of claim 12 or claim 13, wherein said diamond is ultra high-grade diamond.

15. The coated diamond particles of any one of claims 12, 13 or 14 wherein said diamond ranges in size from about 5 to about 1000 µm.

16. The coated diamond particles of any one of claims 12, 13, 14 or 15 wherein said coating ranges in thickness from about 0.01 to 1.5 µm.
